# EUROPEAN PATENT SPECIFICATION

(11) **EP 1 728 327 B1**
(45) Date of publication and mention of the grant of the patent: **02.07.2008**
(21) Application number: 05708909.6
(22) Date of filing: 02.03.2005
(51) Int. Cl.: H03L 7/197, H03K 23/66

(54) **DEVICE COMPRISING A FREQUENCY DIVIDER**
EINRICHTUNG MIT EINEM FREQUENZTEILER
DISPOSITIF COMPRENANT UN DIVISEUR DE FREQUENCE

(30) Priority: 12.03.2004 EP 04101016
(43) Date of publication of application: 06.12.2006
(73) Proprietor: NXP B.V., 5656 AG Eindhoven (NL)
(72) Inventor: FRAMBACH, Johannes, P., A.,, NL-5656 AA Eindhoven (NL)
(74) Representative: Eleveld, Koop Jan
(86) International application number: PCT/IB2005/050772
(87) International publication number: WO 2005/091507

(56) References cited:
- WO-A-03/019781
- US-A- 5 195 111
- US-A1- 2003 030 471
- US-A1- 2003 108 143

## Description

The invention relates to a device comprising a frequency divider, and also relates to a frequency divider, to a section of a second type for use in the frequency divider, and to a method for frequency division.

Examples of such a device are audio receivers and/or transmitters, video receivers and/or transmitters, radio receivers and/or transmitters, mobile terminals, measurement equipment and tuning units like phase locked loops and synthesizers.

A prior art device is known from US 2003/0030471 A1, which discloses an apparatus comprising frequency dividing sections. Each section divides an original frequency by an adjustable number, like for example either the value "two" or the value "three". By adjusting this number per section, in other words by instructing each section to divide for example either by the value "two" or by the value "three", the fractional frequency divider on average divides the original frequency by a fractional divisor N_{f}. Via adjustment signals used for instructing the sections, an integer Nₖ being the sum of all adjustable numbers of all sections can be varied within an octave. In case the integer Nₖ is to be varied more than an octave, the number of sections may need to be extended.

To allow a division by a fractional divisor N_{f}, the adjusting, being the momentary divisor Nₖ, must be changed every total division cycle (indicated by the end-of-cycle logic), such that the desired fractional divisor is realized on average. Thereto, a modulator is to be added, like for example a delta sigma modulator. Then, each section receives an adjustment signal which is modulated, to realize the desired average output frequency.

The known device is disadvantageous, inter alia, due to each section needing to be modulated to allow a division by a fractional divisor N_{f}. In case of the number of sections needing to be extended, the modulation must also be extended.

US patent No 5,195,111 discloses a fractional divder with a chain of divider sections, wherein there are two adjustment signals to adjust the number by which the first section in the chain divides its input frequency. Circuitry is provided to enable devision with the numbers indicated by the two signals in different division cycles of the first section. No modulation is used.

It is an object of the invention, inter alia, to provide a device in which the modulation can be done independently of the number of sections of the frequency divider.

Furthers objects of the invention are, inter alia, to provide a frequency divider, a section of a second type for use in the frequency divider, and a method for frequency division, in which the modulation can be done independently of the number of sections/steps of the frequency divider.

The invention provides for a device as set forth in claim 1.

The first section is a basic section of a first type, which divides a first input frequency by a first adjustable number in dependence of a first adjustment signal and in dependence of a first control signal originating from a later section. Such a later section is a section which receives and divides a lower input frequency compared to an earlier section. The control signal indicates an end-of-cycle. The second section is an advanced section of a second type which not only divides a second input frequency by a second adjustable number in dependence of a second adjustment signal and in dependence of a second control signal originating from a further later section, but also takes care, via the circuitry, of a control of at least one section in dependence of a modulation signal and in dependence of a third control signal originating from a yet further later section. By supplying the modulation signal as well as the third control signal originating from the yet further later section to this circuitry, only the section of the second type and/or only the previous (read: neighbouring earlier) section of the first type need(s) to be modulated, to allow a division by a fractional divisor on average. All later sections no longer require any modulation. As a result, the number of sections can now be extended, by adding later sections, without needing to extend the modulation.

It should be noted that US 2003/0108143 A1 discloses a frequency divider with a delta sigma modulator. However, firstly, the sections in this frequency divider do not receive control signals from later sections, which makes this frequency divider completely different from the frequency divider according to the invention, and, secondly, there is no circuitry for controlling at least one section in dependence of a modulation signal and in dependence of a third control signal originating from a yet further later section. The frequency divider disclosed in US 2003/0108143 A1 cannot be extended without, at the same time, extending the delta sigma modulator including a circuit between the delta sigma modulator and the frequency divider.

An embodiment of the system according to the invention is defined by further comprising
- at least one section of a third type for, in an active mode, dividing a third input frequency by a third adjustable number in dependence of a third adjustment signal and for generating a fourth control signal destined for an earlier section, and for, in an inactive mode, not participating in a frequency division.
   A section of a third type is a so-called programmable section, which has an active and an inactive mode. In the active mode, the frequency divider is extended with this section, and in the inactive mode, this section does not participate in the frequency division. Due to the section of the second type taking care of any modulation, the section of the third type can be introduced advantageously.
   An embodiment of the system according to the invention is defined by a first section, a third section and a fourth section each comprising a section of the first type, with a second section comprising a section of the second type, and with the frequency divider comprising
- further circuitry for converting two original adjustment signals and two original modulation signals into the first adjustment signal destined for the first section and into the second adjustment signal and a first and second modulation signal destined for the second section.
   The third section generates the second control signal and the third section generates the third control signal. The second section controls, in response to the third control signal and the first and second modulation signal, itself and the first section. The further circuitry takes care of overflow problems.
   An embodiment of the system according to the invention is defined by the section of the second type comprising a first latch, a first gate, a second latch, an invertor, a third latch, a second gate, a fourth latch, a third gate, a first multiplexer, a second multiplexer, a fifth latch, a fourth gate, and a sixth latch, with the circuitry comprising the fifth and sixth latch, the first and second multiplexer and the fourth gate.
   This embodiment comprises a low cost, reliable and robust frequency divider, which can be implemented easily.
   An embodiment of the system according to the invention is defined by the section of the first type comprising a first latch, a first gate, a second latch, an invertor, a third latch, a second gate, a fourth latch, and a third.
   This embodiment comprises a low cost, reliable and robust frequency divider, which can be implemented easily.
   An embodiment of the system according to the invention is defined by the section of the third type comprising a first latch, a first gate, a second latch, an invertor, a third latch, a second gate, a fourth latch, a third, a fourth gate, and a fifth gate.
   This embodiment comprises a low cost, reliable and robust frequency divider, which can be implemented easily.
   An embodiment of the system according to the invention is defined by further comprising a tuning unit, which tuning unit comprises the frequency divider. Such a tuning unit comprises a phase locked loop further for example comprising a phase detector and a controlled oscillator, or comprises a synthesizer.
   Embodiments of the frequency divider according to the invention and of the section of the second type according to the invention and of the method according to the invention correspond with the embodiments of the device according to the invention.
   The invention is based upon an insight, inter alia, that, to allow a division by a non-integer, it is sufficient to modulate a few of the sections of the frequency divider only, and is based upon a basic idea, inter alia, that a section of a second type can take care of controlling itself and/or of controlling the previous (read: neigbouring earlier) section of the first type via the control signal for introducing any modulation.
   The invention solves the problem, inter alia, to provide a device in which the modulation can be done independently of the number of sections of the frequency divider, and is advantageous, inter alia, in that such a frequency divider can easily be made low cost, reliable and robust and can easily be implemented.
   These and other aspects of the invention will be apparent from and elucidated with reference to the embodiments(s) described hereinafter.

In the drawings:
Fig. 1 shows in block diagram form a device according to the invention comprising a frequency divider according to the invention;
Fig. 2 shows in block diagram form a section of a first type of the frequency divider according to the invention;
Fig. 3 shows in block diagram form a section of a second type according to the invention of the frequency divider according to the invention; and
Fig. 4 shows in block diagram form a section of a third type of the frequency divider according to the invention.

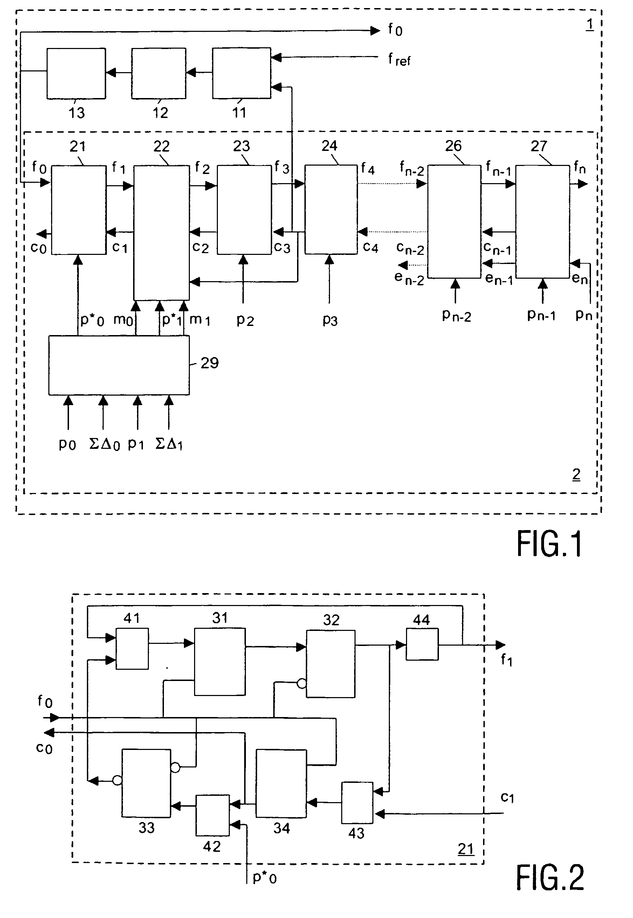

The device 1 according to the invention as shown in Fig. 1 comprises a tuning unit 2,1 1,12,13. This tuning unit in the form of a phase locked loop comprises a frequency divider 2 according to the invention. A voltage controlled oscillator 13 generates an output frequency signal f₀, which in the form of a first input frequency signal f₀ is supplied to an input of the frequency divider 2. The voltage controlled oscillator 13 receives a control voltage via a filter 12 from a phase detector 11. This phase detector 11 receives a reference frequency signal f_{ref} and an output frequency signal from the frequency divider 2. Alternatively, the tuning unit may for example comprise a synthesizer etc.

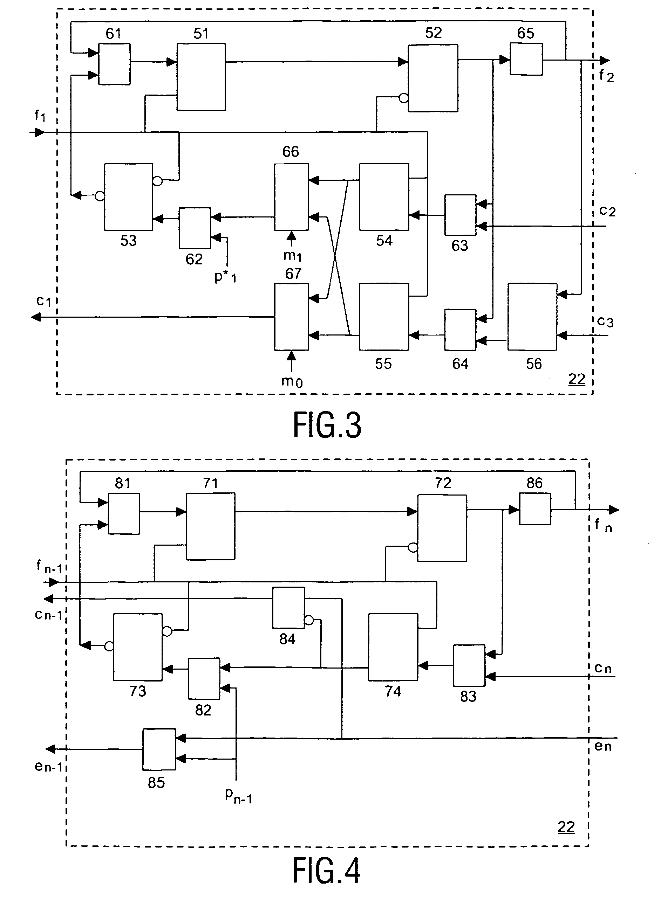

The frequency divider 2 comprises, in this example, a first section 21, a second section 22, a third section 23, a fourth section 24.......a sixth section 26 and a seventh section 27. The first section 21 is a section of a first type for dividing a first input frequency signal f₀ by a first adjustable number in dependence of a first adjustment signal p*₀ and in dependence of a first control signal c₁ originating from a later section 22. The first section 21 generates a control signal c₀ which is not used due to the first section 21 being the first section. The second section 22 is a section of a second type for dividing a second input frequency f₁ by a second adjustable number in dependence of a second adjustment signal p*₁ and in dependence of a second control signal c₂ originating from a further later section 23, which section of the second type comprises circuitry 55,56,64,66,67 to be discussed at the hand of Fig. 3 for controlling at least one section 21,22 in dependence of a modulation signal m₀,m₁ and in dependence of a third control signal c₃ originating from a yet further later section 24.

The third section 23 is again a section of a first type for dividing a frequency signal f₂ by an adjustable number in dependence of an adjustment signal p₂ and in dependence of a control signal c₃ originating from a later section 24. The fourth section 24 is also a section of a first type for dividing a frequency signal f₃ by an adjustable number in dependence of an adjustment signal p₃ and in dependence of a control signal c₄ originating from a later section.

The sixth section 26 is a section of a third type for, in an active mode, dividing a frequency signal fₙ₋₂ by an adjustable number in dependence of an adjustment signal pₙ₋₂ and for generating a control signal cₙ₋₂ destined for an earlier section, and for, in an inactive mode, not participating in a frequency division. The seventh section 27 is a section of a third type for, in an active mode, dividing a third input frequency signal fₙ₋₁ by a third adjustable number in dependence of a third adjustment signal pₙ₋₁ and for generating a fourth control signal Cₙ₋₁ destined for an earlier section 26, and for, in an inactive mode, not participating in a frequency division. The seventh section 27 receives an enable/disable signal eₙ for switching the seventh section 27 into an active/inactive mode. The enable/disable signal eₙ is equal to pₙ due to the seventh section being the final section. The seventh section 27 further receives a control signal Cₙ which is equal to the value "one" due to the seventh section being the final section. The seventh section 27 generates an enable/disable signal eₙ₋₁ destined for the sixth section 26 for switching the sixth section 26 into an active/inactive mode, etc.

The frequency divider 2 further comprises further circuitry 29 for converting two original adjustment signals p₀,p₁ and two original modulation signals ΣΔ₀, ΣΔ₁ into the first adjustment signal p*₀ destined for the first section 21 and into the second adjustment signal p*₁ and a first and second modulation signal m₀, m₁ destined for the second section 22.

The section 21 of the first type of the frequency divider 2 according to the invention as shown in Fig. 2 in block diagram form comprises
- a first latch 31 clocked by the first input frequency signal f₀ and comprising an input coupled to an output of a first AND gate 41;
- a second latch 32 clocked by the inverted first input frequency signal f₀ and comprising an input coupled to an output of the first latch 31 and comprising an output coupled to an input of an invertor 44 for, at an output of the invertor 44, generating an output frequency signal f₁, which output of the invertor 44 is coupled to a first input of the first AND gate 41;
- a third latch 33 clocked by the inverted first input frequency signal f₀ and comprising an input coupled to an output of a second AND gate 42 and comprising an inverted output coupled to a second input of the first AND gate 41; and
- a fourth latch 34 clocked by the first input frequency signal f₀ and comprising an input coupled to an output of a third AND gate 43 and comprising an output for generating a control signal c₀, which output is coupled to a first input of the second AND gate 42, which second AND gate 42 comprises a second input for receiving the first adjustment signal p*₀, and which third AND gate 43 comprises a first input coupled to the output of the second latch 32 and comprises a second input for receiving the first control signal c₁.
   The section 22 of the second type according to the invention of the frequency divider 2 according to the invention as shown in Fig. 3 in block diagram form comprises
- a first latch 51 clocked by the second input frequency signal f₁ and comprising an input coupled to an output of a first AND gate 61;
- a second latch 52 clocked by the inverted second input frequency signal f₁ and comprising an input coupled to an output of the first latch 51 and comprising an output coupled to an input of an invertor 65 for, at an output of the invertor 65, generating an output frequency signal f₂, which output of the invertor 65 is coupled to a first input of the first AND gate 61;
- a third latch 53 clocked by the inverted second input frequency signal f₁ and comprising an input coupled to an output of a second AND gate 62 and comprising an inverted output coupled to a second input of the first AND gate 61;
- a fourth latch 54 clocked by the second input frequency signal f₁ and comprising an input coupled to an output of a third AND gate 63 and comprising an output coupled to a first input of a first multiplexer 66 and to a first input of a second multiplexer 67, which first multiplexer 66 comprises an output coupled to a first input of the second AND gate 62 and which third AND gate 63 comprises a first input coupled to the output of the second latch 52;
- a fifth latch 55 clocked by the second input frequency signal f₁ and comprising an input coupled to an output of a fourth AND gate 64 and comprising an output coupled to a second input of the first multiplexer 66 and to a second input of the second multiplexer 67, which fourth AND gate 64 comprises a first input coupled to the output of the second latch 52; and
- a sixth latch 56 clocked by the output frequency signal f₂ and comprising an output coupled to a second input of the fourth AND gate 64;
   whereby the second AND gate 62 comprises a second input for receiving the second adjustment signal p*₁ and the third AND gate 63 comprises a second input for receiving the second control signal c₂ and the sixth latch 56 comprises an input for receiving the third control signal c₃ and the first multiplexer 66 comprises a control input for receiving a first modulation signal m₁ and the second multiplexer 67 comprises a control input for receiving a second modulation signal m₀ and comprises an output for generating a control signal c₁ destined for an earlier section 21, with the circuitry 55,56,64,66,67 comprising the fifth and sixth latch 55,56, the first and second multiplexer 66,67 and the fourth AND gate 64.
   The section 27 of the third type of the frequency divider 2 according to the invention as shown in Fig. 4 in block diagram form comprises
- a first latch 71 clocked by the third input frequency signal fₙ₋₁ and comprising an input coupled to an output of a first AND gate 81;
- a second latch 72 clocked by the inverted third input frequency signal fₙ₋₁ and comprising an input coupled to an output of the first latch 71 and comprising an output coupled to an input of an invertor 86 for, at an output of the invertor 86, generating an output frequency signal fₙ, which output of the invertor 86 is coupled to a first input of the first AND gate 81;
- a third latch 73 clocked by the inverted third input frequency signal fₙ₋₁ and comprising an input coupled to an output of a second AND gate 82 and comprising an inverted output coupled to a second input of the first AND gate 81;
- a fourth latch 74 clocked by the third input frequency signal fₙ₋₁ and comprising an input coupled to an output of a third AND gate 83 and comprising an output coupled to a first input of the second AND gate 82 and to an inverted first input of a fourth OR gate 84, which third AND gate 83 comprises a first input coupled to the output of the second latch 72; and
- a fifth OR gate 85 comprising a first input coupled to a second input of the second AND gate 82 for receiving the third adjustment signal pₙ₋₁ and comprising a second input coupled to a second input of the fourth OR gate 84 for receiving an enable/disable input signal eₙ and comprising an output for generating an enable/disable output signal eₙ₋₁; whereby the third AND gate 83 comprises a second input for receiving a control signal Cₙ and the fourth OR gate 84 comprises an output for generating the fourth control signal Cₙ₋₁.

The operation of the frequency divider 2 as shown in the Figures is as follows. In a prior art situation, the sections 21-24 are each a section of the first type, as shown in Fig. 2, and the sections 26,27 are each a section of the third type, as shown in Fig. 4. So, in that case, the section 22 does not receive the control signal c₃, and the further circuitry 29 is to be ignored. Then, each one of the sections 21-24 divides the incoming frequency signal f₀ by an adjustable number, like for example either the value "two" or the value "three". By adjusting this number per section, in other words by instructing each section via its adjustment signal pₙ to divide for example either by the value "two" or by the value "three", the fractional frequency divider 2 on average divides the incoming frequency signal f₀ by a fractional divisor N_{f}. As a result, the final frequency signal fₙ is of a reduced frequency and has an increased time period for increasing values of n. The control signal Cₙ is an end-of-cycle signal. This end-of-cycle signal is of the same lowest frequency between each pair of sections, in other words it is at the same output frequency as the frequency signal fₙ as adjusted via the adjustment signals pₙ, and has a reduced duty cycle for reduced values of n. Via the adjustment signals pₙ used for instructing the sections, an integer Nₖ being the sum of all adjustable numbers of all sections can be varied within an octave. In case the integer Nₖ is to be varied more than an octave, the number of sections may need to be extended. For example, in case of a fractional divisor having a value of 31.6 is to be realised, the integer Nₖ may need to get the values 30,31,32 and 33 such that the average value becomes 31.6. Due to an octave border in this case being situated between the values 31 and 32 (32=2⁵), each time the integer Nₖ needs to get the value 32 or 33, the number of sections need to be extended with one section.

Thereto, the programmable sections 26,27 have been added. These sections 26,27 each have an active and an inactive mode. In the active mode, the frequency divider 2 is extended with this section, and in the inactive mode, this section does not participate in the frequency division. Whether the section 26, 27 is in the active mode or the inactive mode is determined via the enable/disable signal eₙ. Because of the sections 26,27 sometimes being in an inactive mode, the outgoing frequency signal fₙ of these sections 26,27 can no longer be used as an output frequency signal for the phase detector 11. Therefore, for example the control signal c₃ is used as output frequency signal. As stated before, this end-of-cycle signal is also at the output frequency as adjusted via the adjustment signals pₙ.

To allow a division by a fractional divisor N_{f}, the adjusting, being the momentary divisor Nₖ, must be changed every total division cycle (indicated by the end-of-cycle logic), such that the desired fractional divisor is realized on average. Thereto, a modulator is to be added, like for example a delta sigma modulator. Then, each section receives an adjustment signal which is modulated. In the prior art situation, this would mean that, in case the frequency divider is extendable via programmable sections, the modulator must be extendable too. This is disadvantageous.

According to the invention, the prior art second section 22 of the first type is replaced by a second section 22 of the second type according to the invention as shown in Fig. 2. The circuitry 55,56,64,66,67, which makes the section of the second type according to the invention different from the section of the first type, has the following function. When dividing by the value "two" or "three", a section in fact counts until the value "two" or "three". As soon as this value has been reached, a next section counts until the value "two" or "three". The delta sigma modulator in fact implies an additional count of the value "minus one", "zero", "one" or "two". In praxis, for example, firstly a value "one" is subtracted, and then secondly an additional count of the value "zero", "one", "two" or "three" is done. Additional counting with the value "one" is done with the first section 21, additional counting with the value "two" is done with the second section 22, and additional counting with the value "three" is done with both first and second sections 21 and 22.

So, the sigma delta modulator only effects the first and second section 21 and 22. The circuitry 55,56,64,66,67 causes the second section 22 directly and the first section 21 indirectly via the control signal c₁ to additional count (or swallow) each once more or not. The further circuitry 29 thereby prevents overflow problems:
p*₁ = p₁ + ΣΔ₁, p*₀ = p₀ + ΣΔ₀, m₁ = p₁ **·** ΣΔ₁ and m₀ = p₀ **·** ΣΔ₀. This is shown in the following table, whereby 1x and 2x indicate the number of swallow actions and whereby x indicates don't care:

| p₁ | p₀ | ΣΔ₁ | ΣΔ₀ | 22 | 21 | p*₁ | p*₀ | m₁ | m₀ |
|---|---|---|---|---|---|---|---|---|---|
| 0 | 0 | 0 | 0 | 0 | 0 | 0 | 0 | x | x |
| 0 | 0 | 0 | 1 | 0 | 1x | 0 | 1 | x | 0 |
| 0 | 0 | 1 | 0 | 1x | 0 | 1 | 0 | 0 | x |
| 0 | 0 | 1 | 1 | 1x | 1x | 1 | 1 | 0 | 0 |
| 0 | 1 | 0 | 0 | 0 | 1x | 0 | 1 | x | 0 |
| 0 | 1 | 0 | 1 | 0 | 2x | 0 | 1 | x | 1 |
| 0 | 1 | 1 | 0 | 1x | 1x | 1 | 1 | 0 | 0 |
| 0 | 1 | 1 | 1 | 1x | 2x | 1 | 1 | 0 | 1 |
| 1 | 0 | 0 | 0 | 1x | 0 | 1 | 0 | 0 | x |
| 1 | 0 | 0 | 1 | 1 x | 1x | 1 | 1 | 0 | 0 |
| 1 | 0 | 1 | 0 | 2x | 0 | 1 | 0 | 1 | x |
| 1 | 0 | 1 | 1 | 2x | 1x | 1 | 1 | 1 | 0 |
| 1 | 1 | 0 | 0 | 1x | 1x | 1 | 1 | 0 | 0 |
| 1 | 1 | 0 | 1 | 1x | 2x | 1 | 1 | 0 | 1 |
| 1 | 1 | 1 | 0 | 2x | 1x | 1 | 1 | 1 | 0 |
| 1 | 1 | 1 | 1 | 2x | 2x | 1 | 1 | 1 | 1 |

Of course, the delta sigma modulator may generate, instead of a two bits value, a three bits value, in which case more than two sections will need to be manipulated and more than one section will need to be of the second type, etc. Further, other modulators than delta sigma modulators may be used, and other latches, other gates and other circuitry and other further circuitry may be used, without departing from the scope of this invention.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. Device (1) comprising a frequency divider (2), which frequency divider (2) comprises a chain of sections, comprising:
- a first section (21) for dividing a first input frequency (f₀) by a first adjustable number in dependence of a first adjustment signal (p*₀) when enabled by a first control signal (c₁) originating from a second, later section (22) in the chain; and
- the second section (22) for dividing a second input frequency (f₁) from the first section by a second adjustable number in dependence of a second adjustment signal (p*₁) when enabled by a second control signal (c₂) originating from a further later section (23) in the chain;
**characterized in that** the second section (22) comprises circuitry (55,56,64,66,67) for enabling division by the first and/or second adjustable number in the first and/or second section (21,22) respectively, when enabled by a third control signal (c₃) originating from a yet further later section (24) in the chain, said circuitry being configured to select between said enabling using the second control signal (c2) and said enabling using the third control signal (c3) under control of a modulation signal (m₀,m₁).

2. Device (1) according to claim 1, further comprising
- a third section (27) for, in an active mode, dividing a third input frequency (fₙ₋₁) by a third adjustable number in dependence of a third adjustment signal (pₙ₋₁) and for generating a fourth control signal (cₙ₋₁) destined for an earlier section (26), and for, in an inactive mode, not participating in a frequency division.

3. Device (1) according to claim 1, comprising a third and fourth second in the chain of a same type as the first section, and with the frequency divider (2) comprising
- further circuitry (29) for converting two original adjustment signals (p₀,p₁) and two original modulation signals (ΣΔ₀,ΣΔ₁) into the first adjustment signal (p*₀) destined for the first section (21) and into the second adjustment signal (p*₁) and a first and second modulation signal (m₀, m₁)destined for the second section (22).

4. Device according to claim 1, wherein the second section (22) comprises
- a first latch (51) clocked by the second input frequency (f₁) and comprising an input coupled to an output of a first gate (61);
- a second latch (52) clocked by the inverted second input frequency (f₁) and comprising an input coupled to an output of the first latch (51) and comprising an output coupled to an input of an invertor (65) for, at an output of the invertor (65), generating an output frequency (f₂), which output of the invertor (65) is coupled to a first input of the first gate (61);
- a third latch (53) clocked by the inverted second input frequency (f₁) and comprising an input coupled to an output of a second gate (62) and comprising an inverted output coupled to a second input of the first gate (61);
- a fourth latch (54) clocked by the second input frequency (f₁) and comprising an input coupled to an output of a third gate (63) and comprising an output coupled to a first input of a first multiplexer (66) and to a first input of a second multiplexer (67), which first multiplexer (66) comprises an output coupled to a first input of the second gate (62) and which third gate (63) comprises a first input coupled to the output of the second latch (52);
- a fifth latch (55) clocked by the second input frequency (f₁) and comprising an input coupled to an output of a fourth gate (64) and comprising an output coupled to a second input of the first multiplexer (66) and to a second input of the second multiplexer (67), which fourth gate (64) comprises a first input coupled to the output of the second latch (52); and
- a sixth latch (56) clocked by the output frequency (f₂) and comprising an output coupled to a second input of the fourth gate (64);
whereby the second gate (62) comprises a second input for receiving the second adjustment signal (p*₁) and the third gate (63) comprises a second input for receiving the second control signal (c₂) and the sixth latch (56) comprises an input for receiving the third control signal (c₃) and the first multiplexer (66) comprises a control input for receiving a first modulation signal (m₁) and the second multiplexer (67) comprises a control input for receiving a second modulation signal (m₀) and comprises an output for generating a control signal (c₁) destined for an earlier section (21), with the circuitry comprising the fifth and sixth latch (55,56), the first and second multiplexer (66,67) and the fourth gate (64).

5. Device (1) according to claim 1, wherein the first section (21) comprises
- a first latch (31) clocked by the first input frequency (f₀) and comprising an input coupled to an output of a first gate (41);
- a second latch (32) clocked by the inverted first input frequency (f₀) and comprising an input coupled to an output of the first latch (31) and comprising an output coupled to an input of an invertor (44) for, at an output of the invertor (44), generating an output frequency (f₁), which output of the invertor (44) is coupled to a first input of the first gate (41);
- a third latch (33) clocked by the inverted first input frequency (f₀) and comprising an input coupled to an output of a second gate (42) and comprising an inverted output coupled to a second input of the first gate (41); and
- a fourth latch (34) clocked by the first input frequency (f₀) and comprising an input coupled to an output of a third gate (43) and comprising an output for generating a control signal (c₀), which output is coupled to a first input of the second gate (42), which second gate (42) comprises a second input for receiving the first adjustment signal (p*₀), and which third gate (43) comprises a first input coupled to the output of the second latch (32) and comprises a second input for receiving the first control signal (c₁).

6. Device (1) according to claim 2, wherein the third section (27) comprises
- a first latch (71) clocked by the third input frequency (fₙ₋₁) and comprising an input coupled to an output of a first gate (81);
- a second latch (72) clocked by the inverted third input frequency (fₙ₋₁) and comprising an input coupled to an output of the first latch (71) and comprising an output coupled to an input of an invertor (86) for, at an output of the invertor (86), generating an output frequency (fₙ), which output of the invertor (86) is coupled to a first input of the first gate (81);
- a third latch (73) clocked by the inverted third input frequency (fₙ₋₁) and comprising an input coupled to an output of a second gate (82) and comprising an inverted output coupled to a second input of the first gate (81);
- a fourth latch (74) clocked by the third input frequency (fₙ₋₁) and comprising an input coupled to an output of a third gate (83) and comprising an output coupled to a first input of the second gate (82) and to an inverted first input of a fourth gate (84), which third gate (83) comprises a first input coupled to the output of the second latch (72); and
- a fifth gate (85) comprising a first input coupled to a second input of the second gate (82) for receiving the third adjustment signal (pₙ₋₁) and comprising a second input coupled to a second input of the fourth gate (84) for receiving an enable/disable input signal (eₙ) and comprising an output for generating an enable/disable output signal (eₙ₋₁); whereby the third gate (83) comprises a second input for receiving a control signal (cₙ) and the fourth gate (84) comprises an output for generating the fourth control signal (cₙ₋₁).

7. Device (1) according to claim 1, further comprising a tuning unit (2,11,12,13), which tuning unit comprises the frequency divider (2).

8. Method for frequency division and comprising:
- a step of dividing a first input frequency (f₀) by a first adjustable number in dependence of a first adjustment signal (p*₀) when enabled by a first control signal; and
- a step of dividing a second input frequency (f₁) by a second adjustable number in dependence of a second adjustment signal (p*₁) when enabled by a second control signal (c₂), which step of dividing the second input frequency comprises a substep of originating the first control signal,
- a further step including originating the second control signal (c2);
**characterized in that** the substep comprises enabling division by the first and/or second adjustable number in the step of dividing by the first input frequency and/or in the step of dividing by the second input frequency respectively, when enabled by a third control signal (c₃) originating from a yet further step, in the chain,
- selecting between said enabling using the second control signal (c2) and said enabling using the third control signal (c3) under control of a modulation signal (m₀,m₁).

## Patentansprüche

1. Vorrichtung (1), einen Frequenzteiler (2) umfassend, wobei der Frequenzteiler (2) eine Kette von Sektionen umfasst, umfassend:
- eine erste Sektion (21) zum Teilen einer ersten Eingangsfrequenz (f₀) durch eine erste justierbare Zahl in Abhängigkeit von einem ersten Justiersignal (p*₀), wenn durch ein erstes Steuersignal (c₁) freigegeben, das von einer zweiten späteren Sektion (22) in der Kette ausgeht, und
- die zweite Sektion (22) zum Teilen einer zweiten Eingangsfrequenz (f₁) von der ersten Sektion durch eine zweite justierbare Zahl in Abhängigkeit von einem zweiten Justiersignal (p*₁), wenn durch ein zweites Steuersignal (c₂) freigegeben, das von einer weiteren späteren Sektion (23) in der Kette ausgeht,
**dadurch gekennzeichnet, dass** die zweite Sektion (22) eine Schaltungsanordnung (55, 56, 64, 66, 67) umfasst zur Freigabe der Teilung durch die erste und/oder zweite justierbare Zahl in jeweils der ersten oder zweiten Sektion (21, 22), wenn durch ein drittes Steuersignal (c₃) freigegeben, das von einer noch weiteren späteren Sektion (24) in der Kette ausgeht, wobei diese Schaltungsanordnung so gestaltet ist, dass sie zwischen der Freigabe unter Verwendung des zweiten Steuersignals (c₂) und der Freigabe unter Verwendung des dritten Steuersignals (c₃) unter Steuerung durch ein Modulationssignal (m₀, m₁) auswählt.

2. Vorrichtung (1) nach Anspruch 1, des Weiteren umfassend
- eine dritte Sektion (27) zum Teilen, in einem aktiven Modus, einer dritten Eingangsfrequenz (fₙ₋₁) durch eine dritte justierbare Zahl in Abhängigkeit von einem dritten Justiersignal (pₙ₋₁) und zum Erzeugen eines vierten für eine frühere Sektion (26) bestimmten Steuersignals (cₙ₋₁) und, in einem inaktiven Modus, zur Nichtteilnahme an einer Frequenzteilung.

3. Vorrichtung (1) nach Anspruch 1, eine dritte und vierte Sektion in der Kette von einem gleichen Typus wie dem der ersten Sektion umfassend und wobei der Frequenzteiler (2) umfasst
- weitere Schaltungsanordnung (29) zur Umwandlung von zwei ursprünglichen Justiersignalen (p₀, p₁) und von zwei ursprünglichen Modulationssignalen (ΣΔ₀ΣΔ₁) in das erste für die erste Sektion (21) bestimmte Justiersignal (p*₀) und in das zweite Justiersignal (p*₁) und in ein erstes und zweites für die zweite Sektion (22) bestimmtes Modulationssignal (m₀, m₁).

4. Vorrichtung nach Anspruch 1, wobei die zweite Sektion (22) umfasst
- ein erstes Latch (51), getaktet durch die zweite Eingangsfrequenz (f₁), und einen mit einem Ausgang eines ersten Gates (61) gekoppelten Eingang umfassend,
- ein zweites Latch (52), getaktet durch die umgekehrte zweite Eingangsfrequenz (f₁), und einen mit einem Ausgang des ersten Latchs (51) gekoppelten Eingang umfassend und einen mit einem Eingang eines Inverters (65) gekoppelten Ausgang zum Erzeugen einer Ausgangsfrequenz (f₂) an einem Ausgang des Inverters (65) umfassend, wobei der Ausgang des Inverters (65) mit einem ersten Eingang des ersten Gates (61) gekoppelt ist,
- ein drittes Latch (53), getaktet durch die umgekehrte zweite Eingangsfrequenz (f₁), und einen mit einem Ausgang eines zweiten Gates (62) gekoppelten Eingang umfassend und einen umgekehrten mit einem zweiten Eingang des ersten Gates (61) gekoppelten Ausgang umfassend,
- ein viertes Latch (54), getaktet durch die zweite Eingangsfrequenz (f₁), und einen mit einem Ausgang eines dritten Gates (63) gekoppelten Eingang umfassend und einen mit einem ersten Eingang eines ersten Multiplexers (66) und mit einem ersten Eingang eines zweiten Multiplexers (67) gekoppelten Ausgang umfassend, wobei der erste Multiplexer (66) einen mit einem ersten Eingang des zweiten Gates (62) gekoppelten Ausgang umfasst und wobei das dritte Gate (63) einen ersten mit dem Ausgang des zweiten Latchs (52) gekoppelten Eingang umfasst,
- ein fünftes Latch (55), getaktet durch die zweite Eingangsfrequenz (f₁), und einen mit einem Ausgang eines vierten Gates (64) gekoppelten Eingang umfassend und einen mit einem zweiten Eingang des ersten Multiplexers (66) und mit einem zweiten Eingang des zweiten Multiplexers (67) gekoppelten Ausgang umfassend, wobei das vierte Gate (64) einen ersten mit dem Ausgang des zweiten Latchs (52) gekoppelten Eingang umfasst, und
- ein sechstes Latch (56), getaktet durch die Ausgangsfrequenz (f₂), und einen mit einem zweiten Eingang des vierten Gates (64) gekoppelten Ausgang umfassend,
wobei das zweite Gate (62) einen zweiten Eingang zum Empfangen des zweiten Justiersignals (p*₁) umfasst und das dritte Gate (63) einen zweiten Eingang zum Empfangen des zweiten Steuersignals (c₂) umfasst und das sechste Latch (56) einen Eingang zum Empfangen des dritten Steuersignals (c₃) umfasst und der erste Multiplexer (66) einen Steuereingang zum Empfangen eines ersten Modulationssignals (m₁) umfasst und der zweite Multiplexer (67) einen Steuereingang zum Empfangen eines zweiten Modulationssignals (m₀) umfasst und einen Ausgang zum Erzeugen eines für eine frühere Sektion (21) bestimmten Steuersignals (c₁) umfasst, wobei die Schaltungsanordnung das fünfte und sechste Latch (55, 56), den ersten und zweiten Multiplexer (66, 67) und das vierte Gate (64) umfasst.

5. Vorrichtung (1) nach Anspruch 1, wobei die erste Sektion (21) umfasst
- ein erstes Latch (31), getaktet durch die erste Eingangsfrequenz (f₀), und einen mit einem Ausgang eines ersten Gates (41) gekoppelten Eingang umfassend,
- ein zweites Latch (32), getaktet durch die umgekehrte erste Eingangsfrequenz (f₀), und einen mit einem Ausgang des ersten Latchs (31) gekoppelten Eingang umfassend und einen mit einem Eingang eines Inverters (44) gekoppelten Ausgang zum Erzeugen einer Ausgangsfrequenz (f₁) an einem Ausgang des Inverters (44) umfassend, wobei der Ausgang des Inverters (44) mit einem ersten Eingang des ersten Gates (41) gekoppelt ist,
- ein drittes Latch (33), getaktet durch die umgekehrte erste Eingangsfrequenz (f₀), und einen mit einem Ausgang eines zweiten Gates (42) gekoppelten Eingang umfassend und einen umgekehrten mit einem zweiten Eingang des ersten Gates (41) gekoppelten Ausgang umfassend, und
- ein viertes Latch (34), getaktet durch die erste Eingangsfrequenz (f₀), und einen mit einem Ausgang eines dritten Gates (43) gekoppelten Eingang umfassend und einen Ausgang zum Erzeugen eines Steuersignals (c₀) umfassend, wobei der Ausgang mit einem ersten Eingang des zweiten Gates (42) gekoppelt ist, wobei das zweite Gate (42) einen zweiten Eingang zum Empfangen des ersten Justiersignals (p*₀) umfasst und wobei das dritte Gate (43) einen ersten mit dem Ausgang des zweiten Latchs (32) gekoppelten Eingang umfasst und einen zweiten Eingang zum Empfangen des ersten Steuersignals (c₁) umfasst.

6. Vorrichtung (1) nach Anspruch 2, wobei die dritte Sektion (27) umfasst
- ein erstes Latch (71), getaktet durch die dritte Eingangsfrequenz (fₙ₋₁), und einen mit einem Ausgang eines ersten Gates (81) gekoppelten Eingang umfassend,
- ein zweites Latch (72), getaktet durch die umgekehrte dritte Eingangsfrequenz (fₙ₋₁), und einen mit einem Ausgang des ersten Latchs (71) gekoppelten Eingang umfassend und einen mit einem Eingang eines Inverters (86) gekoppelten Ausgang zum Erzeugen einer Ausgangsfrequenz (fₙ) an einem Ausgang des Inverters (86) umfassend, wobei der Ausgang des Inverters (86) mit einem ersten Eingang des ersten Gates (81) gekoppelt ist,
- ein drittes Latch (73), getaktet durch die umgekehrte dritte Eingangsfrequenz (fₙ₋₁), und einen mit einem Ausgang eines zweiten Gates (82) gekoppelten Eingang umfassend und einen umgekehrten mit einem zweiten Eingang des ersten Gates (81) gekoppelten Ausgang umfassend,
- ein viertes Latch (74), getaktet durch die dritte Eingangsfrequenz (fₙ₋₁), und einen mit einem Ausgang eines dritten Gates (83) gekoppelten Eingang umfassend und einen mit einem ersten Eingang des zweiten Gates (82) und mit einem umgekehrten ersten Eingang eines vierten Gates (84) gekoppelten Ausgang umfassend, wobei das dritte Gate (83) einen ersten mit dem Ausgang des zweiten Latchs (72) gekoppelten Eingang umfasst, und
- ein fünftes einen ersten mit einem zweiten Eingang des zweiten Gates (82) gekoppelten Eingang umfassendes Gate (85) zum Empfangen des dritten Justiersignals (pₙ₋₁) und einen zweiten mit einem zweiten Eingang des viertens Gates (84) gekoppelten Eingang zum Empfangen eines Freigeben/Sperren-Eingangssignals (eₙ) umfassend und einen Ausgang zum Erzeugen eines Freigeben/Sperren-Ausgangssignals (eₙ₋₁) umfassend, wobei das dritte Gate (83) einen zweiten Eingang zum Empfangen eines Steuersignals (cₙ) umfasst und das vierte Gate (84) einen Ausgang zum Erzeugen des vierten Steuersignals (c_{n -1}) umfasst.

7. Vorrichtung (1) nach Anspruch 1, des Weiteren einen Abstimmsatz (2, 11, 12, 13) umfassend, wobei der Abstimmsatz den Frequenzteiler (2) umfasst.

8. Verfahren zur Frequenzteilung und umfassend:
- einen Schritt des Teilens einer ersten Eingangsfrequenz (f₀) durch eine erste justierbare Zahl in Abhängigkeit von einem ersten Justiersignal (p*₀), wenn durch ein erstes Steuersignal freigegeben, und
- einen Schritt des Teilens einer zweiten Eingangsfrequenz (f₁) durch eine zweite justierbare Zahl in Abhängigkeit von einem zweiten Justiersignal (p*₁), wenn durch ein zweites Steuersignal (c₂)freigegeben, wobei der Schritt des Teilens der zweiten Eingangsfrequenz einen Unterschritt des Erzeugens des ersten Steuersignals umfasst,
- einen weiteren Schritt, das Erzeugen des zweiten Steuersignals (c₂) umfassend, **dadurch gekennzeichnet, dass** der Unterschritt Teilung durch die erste und/oder zweite justierbare Zahl jeweils in dem Schritt des Teilens durch die erste Eingangsfrequenz und/oder in dem Schritt des Teilens durch die zweite Eingangsfrequenz ermöglicht, wenn durch ein drittes von einem noch weiteren Schritt in der Kette ausgehendes Steuersignal (c₃) freigegeben,
- Auswahl zwischen der Freigabe unter Verwendung des zweiten Steuersignals (c₂) und der Freigabe unter Verwendung des dritten Steuersignals (c₃) unter Steuerung durch eine Modulationssignal (m₀, m₁).

## Revendications

1. Dispositif (1) comprenant un diviseur de fréquence (2), lequel diviseur de fréquence (2) comprend une chaîne de sections, comprenant :
- une première section (21) pour diviser une première fréquence d'entrée (f₀) par un premier nombre ajustable en fonction d'un premier signal d'ajustement (p*₀) lorsque celui-ci est activé par un premier signal de commande (c₁) provenant d'une deuxième section (22) plus loin dans la chaîne ; et
- la deuxième section (22) pour diviser une deuxième fréquence d'entrée (f₁) provenant de la première section par un deuxième nombre ajustable en fonction d'un deuxième signal d'ajustement (p*₁) lorsque celui-ci est activé par un deuxième signal de commande (c₂) provenant d'une autre section (23) plus loin dans la chaîne ; **caractérisé par le fait que** la deuxième section (22) comprend une circuiterie (55, 56, 64, 66, 67) pour permettre la division par le premier et/ou le deuxième nombre ajustable dans la première et/ou la deuxième section (21, 22) respectivement, lorsque celle-ci est activée par un troisième signal de commande (c₃) provenant d'une section (24) située encore plus loin dans la chaîne, ladite circuiterie étant configurée pour choisir entre ladite activation à l'aide du deuxième signal de commande (c₂) et ladite activation à l'aide du troisième signal de commande (c₃) sous le contrôle d'un signal de modulation (m₀, m₁).

2. Dispositif (1) selon la revendication 1, comprenant en outre :
- une troisième section (27), pour diviser en mode actif une troisième fréquence d'entrée (fₙ₋₁) par un troisième nombre ajustable en fonction d'un troisième signal d'ajustement (pₙ₋₁) et pour générer un quatrième signal de commande (cₙ₋₁) destiné à une section (26) en amont dans la chaîne, et pour ne pas participer à une division de fréquence en mode inactif.

3. Dispositif (1) selon la revendication 1, comprenant une troisième et une quatrième section dans la chaîne du même type que la première section, le diviseur de fréquence (2) comprenant :
- une circuiterie supplémentaire (29) pour convertir deux signaux d'ajustement originels (p₀, p₁) et deux signaux de modulation originels (ΣΔ₀, ΣΔ₁) en un premier signal d'ajustement (p*₀) destiné à la première section (21) et en un deuxième signal d'ajustement (p*₁) et un premier et deuxième signal de modulation (m₀, m₁) destinés à la deuxième section (22).

4. Dispositif selon la revendication 1, dans lequel la deuxième section (22) comprend
- une première bascule (51) synchronisée par la deuxième fréquence d'entrée (f₁) et comportant une entrée raccordée à une sortie d'une première porte (61) ;
- une deuxième bascule (52) synchronisée par la deuxième fréquence d'entrée inversée (f₁) et comportant une entrée raccordée à une sortie de la première bascule (51) et comportant une sortie raccordée à une entrée d'un inverseur (65) pour générer, à la sortie de l'inverseur (65), une fréquence de sortie (f₂), la sortie de l'inverseur (65) étant raccordée à une première entrée de la première porte (61) ;
- une troisième bascule (53) synchronisée par la deuxième fréquence d'entrée inversée (f₁) et comportant une entrée raccordée à une sortie d'une deuxième porte (62) et comportant une sortie inversée raccordée à une deuxième entrée de la première porte (61) ;
- une quatrième bascule (54) synchronisée par la deuxième fréquence d'entrée (f₁) et comportant une entrée raccordée à une sortie d'une troisième porte (63) et comportant une sortie raccordée à une première entrée d'un premier multiplexeur (66) et à une première entrée d'un deuxième multiplexeur (67), le premier multiplexeur (66) comportant une sortie raccordée à une première entrée de la seconde porte (62) et la troisième porte (63) comportant une première entrée raccordée à la sortie de la deuxième bascule (52) ;
- une cinquième bascule (55) synchronisée par la deuxième fréquence d'entrée (f₁) et comportant une entrée raccordée à une sortie d'une quatrième porte (64) et comportant une sortie raccordée à une deuxième entrée du premier multiplexeur (66) et à une deuxième entrée du deuxième multiplexeur (67), la quatrième porte (64) comportant une première entrée raccordée à la sortie de la deuxième bascule (52) ; et
- une sixième bascule (56) synchronisée par la fréquence de sortie (f₂) et comportant une sortie raccordée à une deuxième entrée de la quatrième porte (64) ; la deuxième porte (62) comporte une deuxième entrée pour recevoir le deuxième signal d'ajustement (p*₁), la troisième porte (63) comporte une deuxième entrée pour recevoir le deuxième signal de commande (c₂), la sixième bascule (56) comporte une entrée pour recevoir le troisième signal de commande (c₃) et le premier multiplexeur (66) comporte une entrée de commande pour recevoir un premier signal de modulation (m₁), le deuxième multiplexeur (67) comporte une entrée de commande pour recevoir un deuxième signal de modulation (m₀) et comporte une sortie pour générer un signal de commande (c₁) destiné à une section précédente (21), avec une circuiterie comprenant la cinquième et la sixième bascule (55, 56), le premier et le deuxième multiplexeur (66, 67) et la quatrième porte (64).

5. Dispositif (1) selon la revendication 1, dans lequel la première section (21) comprend
- une première bascule (31) synchronisée par la première fréquence d'entrée (f₀) et comportant une entrée raccordée à une sortie d'une première porte (41) ;
- une deuxième bascule (32) synchronisée par la première fréquence d'entrée inversée (f₀) et comportant une entrée raccordée à une sortie de la première bascule (31) et comportant une sortie raccordée à une entrée d'un inverseur (44) pour générer, à la sortie de l'inverseur (44), une fréquence de sortie (f₁), la sortie de l'inverseur (44) étant raccordée à une première entrée de la première porte (41) ;
- une troisième bascule (33) synchronisée par la première fréquence d'entrée inversée (f₀) et comportant une entrée raccordée à une sortie d'une deuxième porte (42) et comportant une sortie inversée raccordée à une deuxième entrée de la première porte (41) ; et
- une quatrième bascule (34) synchronisée par la première fréquence d'entrée (f₀) et comportant une entrée raccordée à une sortie d'une troisième porte (43) et comportant une sortie pour générer un signal de commande (c₀), cette sortie étant raccordée à une première entrée de la deuxième porte (42), ladite seconde porte (42) comportant une deuxième entrée pour recevoir le premier signal d'ajustement (p*₀) et ladite troisième porte (43) comportant une première entrée raccordée à la sortie de la deuxième bascule (32) et comportant une deuxième entrée pour recevoir le premier signal de commande (c₁).

6. Dispositif (1) selon la revendication 2, dans lequel la troisième section (27) comprend
- une première bascule (71) synchronisée par la troisième fréquence d'entrée (fₙ₋₁) et comportant une entrée raccordée à une sortie d'une première porte (81) ;
- une deuxième bascule (72) synchronisée par la troisième fréquence d'entrée inversée (fₙ₋₁) et comportant une entrée raccordée à une sortie de la première bascule (71) et comportant une sortie raccordée à l'entrée d'un inverseur (86) pour générer, à une sortie de l'inverseur (86), une fréquence de sortie (fₙ), la sortie de l'inverseur (86) étant raccordée à une première entrée de la première porte (81) ;
- une troisième bascule (73) synchronisée par la troisième fréquence d'entrée inversée (fₙ₋₁) et comportant une entrée raccordée à une sortie d'une deuxième porte (82) et comportant une sortie inversée raccordée à une deuxième entrée de la première porte (81) ;
- une quatrième bascule (74) synchronisée par la troisième fréquence d'entrée (fₙ₋₁) et comportant une entrée raccordée à une sortie d'une troisième porte (83) et comportant une sortie raccordée à une première entrée de la deuxième porte (82) et à une première entrée inversée d'une quatrième porte (84), ladite troisième porte (83) comportant une première entrée raccordée à la sortie de la deuxième bascule (72) ; et
- une cinquième porte (85) comportant une première entrée raccordée à une deuxième entrée de la deuxième porte (82) pour recevoir le troisième signal d'ajustement (pₙ₋₁) et comportant une deuxième entrée raccordée à une deuxième entrée de la quatrième porte (84) pour recevoir un signal d'entrée d'activation /inhibition (eₙ) et comportant une sortie pour générer un signal de sortie d'activation /inhibition (eₙ₋₁) ; la troisième porte (83) comportant une deuxième entrée pour recevoir un signal de commande (cₙ) et la quatrième porte (84) comportant une sortie pour générer le quatrième signal de commande (cₙ₋₁).

7. Dispositif (1) selon la revendication 1, comprenant en outre une unité d'accord (2, 11, 12, 13), ladite unité d'accord comportant le diviseur de fréquence (2).

8. Procédé de division de fréquence comportant :
- une étape de division d'une première fréquence d'entrée (f₀) par un premier nombre ajustable en fonction d'un premier signal d'ajustage (p*₀) lorsque cette étape est activée par un premier signal de commande ; et
- une étape de division d'une deuxième fréquence d'entrée (f₁) par un deuxième nombre ajustable en fonction d'un deuxième signal d'ajustage (p*₁) lorsque cette étape est activée par un deuxième signal de commande (c₂), cette étape de division de la deuxième fréquence d'entrée comportant une sous-étape consistant à générer le premier signal de commande,
- une étape supplémentaire incluant la génération du deuxième signal de commande (c₂) ;**caractérisé par le fait que** la sous-étape comporte l'activation de la division par le premier et/ou le deuxième nombre ajustable dans l'étape consistant à diviser la première fréquence d'entrée et/ou dans l'étape consistant à diviser la deuxième fréquence d'entrée respectivement, lorsque ceci est activé par un troisième signal de commande (c₃) provenant d'une autre étape ultérieure dans la chaîne,
- le choix entre ladite activation à l'aide du deuxième signal de commande (c₂) et ladite activation à l'aide du troisième signal de commande (c₃) sous le contrôle d'un signal de modulation (m₀, m₁).
